# EUROPÄISCHE PATENTSCHRIFT

(11) **EP 1 832 150 B1**
(45) Veröffentlichungstag und Bekanntmachung des Hinweises auf die Patenterteilung: **13.08.2008**
(21) Anmeldenummer: 05781987.2
(22) Anmeldetag: 29.08.2005
(51) Int. Cl.: H05K 7/20

(54) **KÜHLUNGSSYSTEM FÜR GERÄTE- UND NETZWERKSCHRÄNKE UND VERFAHREN ZUR KÜHLUNG VON GERÄTE- UND NETZWERKSCHRÄNKEN**
COOLING SYSTEM FOR APPLIANCE CABINETS AND NETWORK CABINETS, AND METHOD FOR COOLING APPLIANCE CABINETS AND NETWORK CABINETS
SYSTEME DE REFROIDISSEMENT POUR ARMOIRES D'APPAREILS ET DE RESEAU ET PROCEDE ASSOCIE

(30) Priorität: 11.10.2004 DE 102004049487
(43) Veröffentlichungstag der Anmeldung: 12.09.2007
(73) Patentinhaber: Knürr AG, 94424 Arnstorf (DE)
(72) Erfinder: KOCH, Peter, 86946 Vilgertshofen (DE); EBERMANN, Heiko, 01109 Dresden (DE)
(74) Vertreter: Heim, Hans-Karl
(86) Internationale Anmeldenummer: PCT/EP2005/009299
(87) Internationale Veröffentlichungsnummer: WO 2006/039962

(56) Entgegenhaltungen:
- US-A- 3 387 648
- US-A- 6 041 851
- US-A1- 2002 173 266
- US-A1- 2004 132 398

## Beschreibung

Die Erfindung betrifft ein Kühlungssystem für Geräte- und Netzwerkschränke gemäß dem Oberbegriff des Anspruchs 1 und ein Verfahren zur Kühlung von Geräte- und Netzwerkschränken gemäß dem Oberbegriff des Anspruchs 11 ,vgl. z.B US-A-2004 0132398.

Die Erfindung ist insbesondere für Serverschränke geeignet, welche eine Vielzahl von übereinander oder auch nebeneinander angeordneten Servern als elektronische Moduleinheiten aufweisen.

Es ist bekannt, Serverschränke zu konstruieren, welche keinen Luftwechsel mit der Umgebungsluft zulassen. In der Regel werden diese Serverschränke oder auch Netzwerkschränke nahezu vollständig gegen die Umgebung abgedichtet und genügen beispielsweise einem IP-Schutzwert von IP 55, d.h. sie sind staub- und strahlwasserdicht ausgebildet. Während die Dichtheit gegen Strahlwasser nicht unbedingt erforderlich ist, wird eine luftdichte Konstruktion, welche einen Luftaustausch zwischen dem Schrankinnenraum und dem Aufstellungsraum verhindert, angestrebt. Zu diesem Zweck werden beispielsweise entsprechend wirkungsvolle Abdichtungen im Bereich der Kabelein- und Kabelausführungen vorgesehen, und vom Schrankhersteller wird ausdrücklich auf eine vollständige Abdichtung in diesem Bereich vor der Inbetriebnahme des Schrankes und der Schrankklimatisierung hingewiesen.

Die Entwärmung der elektronischen Moduleinheiten im Innen- oder Aufnahmeraum eines luftdichten Schrankes erfolgt mit Hilfe eines geschlossenen Luftstroms und einem Wärmetauscher, in welchem die Verlustleistung der elektronischen Moduleinheiten abgeführt wird.

Für Schränke mit Hochleistungsprozessoren und insbesondere für Serverschränke können zur Abführung der erheblichen Verlustleistungen besonders vorteilhaft Luft-Wasser-Wärmetauscher eingesetzt werden, welche an die Kaltwasserversorgung des Gebäudes angeschlossen sind. Die gesamte Verlustleistung der Schränke kann durch das Kaltwassersystem des Gebäudes entwärmt werden, und ein Wärmeübergang zwischen dem Aufstellungsraum und den Schränken wird vermieden, was zu einer erheblichen Kosteneinsparung aufgrund der geringeren Anforderungen an die Raumklimatisierung und zu einer höheren Belegungsdichte des Aufstellungsraumes führen kann.

Innerhalb des Wärmetauschers kann es zu einer örtlichen Taupunktunterschreitung kommen. Eine Verwendung von Kühlwasser mit einer Temperatur unter 12°C und/oder eine hohe Luftfeuchtigkeit im Aufstellungsraum kann mit einer Kondensatbildung innerhalb des Wärmetauschers verbunden sein. Dadurch wird die absolute Luftfeuchtigkeit innerhalb des Geräteschrankes gesenkt, was zu Schäden an den eingebauten Moduleinheiten und Systemen führen kann.

Der Erfindung liegt die **Aufgabe** zugrunde, ein Kühlungssystem und ein Verfahren zur Kühlung von Geräteschränken und Netzwerkschränken, insbesondere Serverschränken, zu schaffen, welche bei einer außerordentlich hohen und effizienten Kühlleistung die Nachteile einer Kondensatbildung vermeiden.

In Bezug auf das Kühlungssystem wird die Aufgabe erfindungsgemäß durch die Merkmale des Anspruchs 1 und in Bezug auf das Verfahren zur Kühlung durch die Merkmale des Anspruchs 11 gelöst. Zweckmäßige und vorteilhafte Ausgestaltungen sind in den jeweiligen Unteransprüchen und in der Figurenbeschreibung beschrieben.

Das erfindungsgemäße Kühlungssystem geht von einem luftdicht ausgebildeten Schrank mit einem geschlossenen Kühlluftkreislauf aus und sieht eine Stabilisierung der Luftfeuchte im Schrank mit Hilfe einer definierten, Außenluftzuführung vor, welche insbesondere gesteuert sein kann.

Verfahrensmäßig ist vorgesehen, die Luftfeuchte in dem Gehäuse innerhalb von vorgegebenen Grenzen zu halten. Indem die durch einen Kondensationsprozess verringerte absolute Luftfeuchtigkeit wieder erhöht wird, werden Schäden an den eingebauten Geräten, Bauteilen und Systemen vermieden.

Es ist vorteilhaft, dass die Stabilisierung der Luftfeuchte nur in dem Maße durchgeführt wird, wie es zum sicheren Betrieb der eingebauten Elektronik erforderlich ist. Um eine ständige Entfeuchtung der Luft zu vermeiden, wird deshalb definiert Außenluft in den Schrank geführt.

Für die Zuführung der Außenluft können gezielt Unterbrechungen oder Undichtigkeiten im Schrank, beispielsweise in den Verkleidungsteilen wie Sockel, Abdeckung, rückseitiger und frontseitiger Tür, vorgesehen werden. Über diese Unterbrechungen oder Undichtigkeiten kann dann Außenluft zur steuerbaren Beeinflussung der Luftfeuchte in den Schrank eingeführt werden.

Verfahrensmäßig ist es zweckmäßig, die Luftfeuchte im Schrank bzw. des Kühlluftstromes zu messen und in Abhängigkeit von den Umgebungsbedingungen und den Zielwerten im Schrank die Undichtigkeiten bzw. Unterbrechungen auszulegen, so dass die erforderliche Außenluftmenge in das Schrankinnere gelangen kann.

Besonders vorteilhaft können für eine definierte Außenluftzuführung Differenzdrücke zwischen dem Schrankinneren bzw. dem geschlossenen Kühlluftkreislauf und der Schrankumgebung ausgenutzt werden. Beispielsweise können die Undichtigkeiten oder Unterbrechungen im Bereich eines Lüfters ausgebildet sein. An der Saugseite des Lüfters, an welcher ein Unterdruck gegenüber der Schrankumgebung herrscht, kann eine Öffnung oder Undichtigkeit für eine Außenluftzuführung ausgebildet sein. In einem Bereich, an dem Überdruck gegenüber der Umgebung herrscht, kann ein Luftaustritt aus dem Schrank vorgesehen werden. Indem die unterschiedlichen örtlichen Druckverhältnisse gezielt für die Stabilisierung der Luftfeuchte im Schrankinneren ausgenutzt werden, kann auf zusätzliche Lüfter verzichtet werden.

Vorteilhaft können die Unterbrechungen bzw. Undichtigkeiten im Bereich der Kabeleinführung und/oder Kabelausführung vorgesehen werden, indem z.B. die hier vorgesehenen Abdichtungen derart ausgebildet sind, dass Außenluft eintreten bzw. Luft aus dem Schrankinneren austreten kann.

Eine weitere Möglichkeit besteht darin, die Dichtungsprofile derart auszubilden, dass eine Abdichtung kleiner IP 55 ausgebildet ist und Wasserdampf in definierten Mengen ein- und austreten kann.

Durch die erfindungsgemäße Luftfeuchtestabilisierung werden die Nachteile einer Kondensatbildung und Entfeuchtung unterhalb eines vorgegebenen Wertes bzw. eines Bereiches vermieden und Schäden an den Geräten und Systemen vermieden.

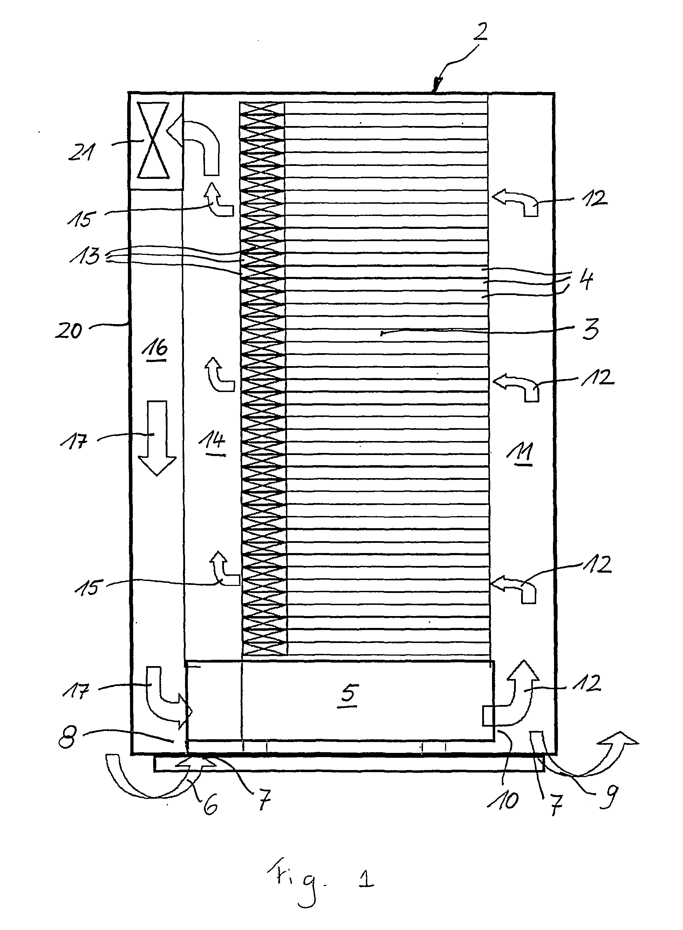

Die Erfindung wird nachstehend anhand einer Zeichnung weiter erläutert. In der einzigen Zeichnung ist in einer stark schematisierten Darstellung ein Geräte- und Netzwerkschrank 2 mit einem Innenraum 3 für elektronische Moduleinheiten 4 gezeigt.

In diesem Beispiel sind als elektronische Moduleinheiten 4 Server übereinander gestapelt angeordnet, welche in einem Gehäuse mit Luftein- und Luftaustrittsöffnungen (nicht dargestellt) aufgenommen sind. In diesem Ausführungsbeispiel ist jeweils ein Lüfter 13 in den Gehäusen der Moduleinheiten 4 vorgesehen. Durch eine Luftführung mit gleich langen Luftwegen und damit gleichen Strömungswiderständen für die einzelnen elektronischen Moduleinheiten 4 und eine lufttechnische Trennung zwischen kalter Zuluft 12 und erwärmter Abluft 9 wird den elektronischen Einheiten 4 Zuluft 12 mit einer einheitlichen Zulufttemperatur, worunter eine Temperatur mit Abweichungen von +/- 2 Kelvingraden verstanden werden soll, zugeführt.

Bodenseitig ist als Wärmetauscher 5 ein Luft-Wasser-Wärmetauscher angeordnet, welchem die in einem geschlossenen Kreislauf geführte Luft zur Entwärmung zugeführt wird. Die im Wärmetauscher 5 abgekühlte Zuluft 12 gelangt über einen Zuluftkanal 11 zu den einzelnen elektronischen Moduleinheiten 4, nimmt die von diesen produzierte Wärme auf und gelangt als erwärmte Abluft in einen ersten Abluftkanal 14. In diesem ersten Abluftkanal 14 wird die Abluft der einzelnen elektronischen Moduleinheiten 4 gesammelt und als aufsteigende Abluftströmung 15 einem zweiten Abluftkanal 16 mit Hilfe wenigstens eines Ventilators 21 zugeführt. In einer absteigenden Abluftströmung 17 gelangt die Abluft in den Wärmetauscher 5 und wird hier mit Hilfe von Kühlwasser aus der Kaltwasserversorgung des Gebäudes abgekühlt.

Zur Stabilisierung der absoluten Luftfeuchte sind im Bereich eines Sockels 18 oder in einem bodenseitigen, insbsondere seitlichen Bereich des Wärmetauschers 5 Undichtigkeiten bzw. Unterbrechungen 7 ausgebildet, über welche eine Außenluftzuführung 6 in den geschlossenen Kühlluftkreislauf möglich ist. Aus der Figur geht hervor, dass die Außenluftzuführung 6 in einem Unterdruckbereich 8, nämlich an der Ansaugseite eines Ventilators 21 in der Abluftströmung 15 erfolgt, während an der Austrittsseite des Ventilators 21, beispielsweise nach dem Wärmetauscher 5 in der abgekühlten Zuluft 12 ein Überdruckbereich 10 ausgebildet ist, aus welchem mittels hier ausgebildeter Undichtigkeiten oder Unterbrechungen 7, Öffnungen und dergleichen Luft abgeführt werden kann.

Wenn in einem unteren Bereich 18 des Geräteschrankes 2, beispielsweise seitlich neben dem Wärmetauscher 5 ein Schacht (nicht dargestellt) vorgesehen ist, welcher auch zur Leitungsführung bzw. zur Kabelein- und/oder Kabelausführung (nicht dargestellt) ausgebildet ist, kann die Außenluftzuführung 6 auch durch eine weniger dichte Ausbildung dieser Kabelein- und/oder -ausführung oder durch Öffnungen in den Schachtwänden (nicht dargestellt) realisiert werden.

Alternativ oder auch zusätzlich können weitere Undichtigkeiten, beispielsweise definierte Öffnungen, auch im Bereich einer frontseitigen Tür 23 und/oder im Bereich der rückseitigen Tür 20 ausgebildet sein.

Eine vorgebbare bzw. steuerbare Außenluftzuführung kann auch über Öffnungen, die mit einem definierten Filter versehen sind, vorgenommen werden.

Die Erfindung ist nicht auf die im Ausführungsbeispiel beschriebenen Serverschränke mit einer Luftführung mit gleich langen Luftwegen und einer lufttechnischen Trennung von Zu- und Abluft begrenzt, sondern für alle Geräte- und Netzwerkschränke mit einem geschlossenen Kühlluftkreislauf verwendbar.

## Patentansprüche

1. Anordnung zum Klimatisieren von in einem Innenraum (3) eines Geräte- und Netzwerkschrankes angeordneten elektronischen Moduleinheiten (4),
mit einem geschlossenen Kühlluftkreislauf und einem Wärmetauscher (5) zur Abführung der von den elektronischen Moduleinheiten (4) erzeugten Verlustwärme,
**dadurch gekennzeichnet,**
**dass** im Bereich der Verkleidungsteile (20, 22, 23) des Schrankes (2) gezielt eingebrachte Öffnungen, Unterbrechungen oder Undichtigkeiten (7) vorgesehen sind, durch welche Außenluft (6) zuführbar ist, um die Luftfeuchte im Innenraum (3) des Schrankes (2) zu stabilisieren.

2. Anordnung nach Anspruch 1,
**dadurch gekennzeichnet,**
**dass** die Undichtigkeiten (7) des Schrankes (2) in Bereichen ausgebildet sind, in welchen im Schrankinneren und außerhalb des Schrankes unterschiedliche Drücke herrschen.

3. Anordnung nach Anspruch 1 oder, 2,
**dadurch gekennzeichnet,**
**dass** eine Undichtigkeit (7) zur Außenluftzuführung (6) in einem Unterdruckbereich (8) und eine Undichtigkeit (7) zur Luftabführung (9) aus dem Schrank (2) in einem Überdruckbereich (10) ausgebildet ist.

4. Anordnung nach einem der vorhergehenden Ansprüche
**dadurch gekennzeichnet,**
**dass** eine Undichtigkeit (7) zur Außenluftzuführung (6) im Bereich der Ansaugseite eines Ventilators (21) für den geschlossenen Kühlluftkreislauf, beispielsweise in einem mit einem Abluftkanal (14) verbundenen Bereich neben dem Wärmetauscher (5), ausgebildet ist,

5. Anordnung nach einem der vorhergehenden Ansprüche,
**dadurch gekennzeichnet,**
**dass** der Wärmetauscher (5) ein Luft-Wasser-Wärmetauscher ist, welcher bodenseitig angeordnet ist.

6. Anordnung nach einem der Ansprüche 3 bis 5,
**dadurch gekennzeichnet,**
**dass** die Undichtigkeit (7) zur Luftabführung, (9) im Bereich der Luftaustrittsseite des Ventilators (21), beispielsweise nach dem Luft-Flüssigkeit-Wärmetauscher (5), ausgebildet ist.

7. Anordnung nach einem der vorhergehenden Ansprüche,
**dadurch gekennzeichnet,**
**dass** die Außenluftzuführung (6) und die Luftabführung (9) in Abhängigkeit von einer Luftfeuchtemessung im Kühlluftkreislauf des Schrankes (2), von den Umgebungsbedingungen des Schrankes (2) und von den Zielwerten im Innenraum (3) des Schrankes (2) steuerbar sind.

8. Anordnung nach einem der vorhergehenden Ansprüche,
**dadurch gekennzeichnet,**
**dass** die Unterbrechungen (7) zur Außenluftzuführung (6) in der Abdichtung der Kabelein- und/oder Kabelausführung im Bereich eines Sockels (18) bzw. in einem unteren Bereich des Schrankes (2) ausgebildet sind, wobei dieser Bereich jeweils mit einem ersten Abluftkanal (14) für eine aufsteigende Abluftströmung (15) verbunden ist.

9. Anordnung nach einem der vorhergehenden Ansprüche,
**dadurch gekennzeichnet,**
**dass** die Unterbrechungen (7) zur Außenluftzuführung (6) in einem Schacht, welcher neben dem Wärmetauscher (5) angeordnet und mit dem ersten Abluftkanal (14) für die aufsteigende Abluftströmung (15) verbunden ist, ausgebildet sind.

10. Anordnung nach einem der vorhergehenden Ansprüche,
**dadurch gekennzeichnet,**
**dass** zur Außenluftzuführung (6) die Abdichtungen des Schrankes (2) bereichsweise kleiner als IP 55 und wasserdampfdurchlässig ausgebildet sind.

11. Verfahren zum Klimatisieren von in einem Geräte- und Netzwerkschrank angeordneten elektronischen Moduleinheiten (4), bei welchem ein Kühlluftstrom in einem geschlossenen Kreislauf geführt wird, wobei kalte Zuluft (12) den elektronischen Moduleinheiten (4) zugeführt und erwärmte Abluft (15, 17) in einem Wärmetauscher (5) abgekühlt wird,
**dadurch gekennzeichnet,**
**dass** zur Vermeidung einer ständigen Entfeuchtung der im geschlossenen Kreislauf geführten Luft die Feuchte des Luftstroms durch eine definierte Zuführung von Außenluft stabilisiert wird.

12. Verfahren nach Anspruch 11,
**dadurch gekennzeichnet,**
**dass** die absolute Feuchte des im geschlossenen Kreislauf geführten Kühlluftstroms gemessen und bei einer Abweichung von einem vorgebbaren Wert oder Bereich Außenluft (6) in Abhängigkeit von den Umgebungsbedingungen des Schrankes (2) und den Zielwerten im Schrank (2) zugeführt wird.

13. Verfahren nach Anspruch 11 oder 12,
**dadurch gekennzeichnet,**
**dass** die Außenluft durch Undichtigkeiten oder Unterbrechungen (7) des Schrankes (2), welche gezielt ausgebildet werden, dem geschlossenen Kühlluftkreislauf zugeführt wird.

14. Verfahren nach einem der Ansprüche 11 bis 13,
**dadurch gekennzeichnet,**
**dass** die Außenluft (6) über Undichtigkeiten (7) in Bereichen, in welchen Differenzdrücke zwischen dem Schrankinneren und der Umgebung des Schrankes (2) herrschen, zugeführt wird.

15. Verfahren nach einem der Ansprüche 11 bis 14,
**dadurch gekennzeichnet,**
**dass** die Außenluft (6) im Bereich von Kabelein- und/oder Kabelausführungen, beispielsweise in einem Sockel (18), zugeführt wird.

16. Verfahren nach Anspruch 15,
**dadurch gekennzeichnet,**
**dass** die Außenluft (6) über Undichtigkeiten der Schrankabdichtung, insbesondere in einem Bereich neben dem Wärmetauscher (5), welcher ein Luft-Flüssigkeit-Wärmetauscher ist und bodenseitig unterhalb der elektronischen Moduleinheiten (4) angeordnet wird, zugeführt wird.

17. Verfahren nach einem der Ansprüche 11 bis 16,
**dadurch gekennzeichnet,**
**dass** die Außenluft über Öffnungen in Verkleidungsteilen (20, 22, 23) zugeführt wird.

18. Verfahren nach einem der Ansprüche 11 bis 17,
**dadurch gekennzeichnet,**
**dass** zur Stabilisierung der Luftfeuchte im Schrank (2) eine Luftabführung (9) aus dem Schrank (2) durchgeführt wird.

19. Verfahren nach Anspruch 18,
**dadurch gekennzeichnet ,**
**dass** Luft (9) in Überdruckbereichen (10) des Schrankes (2) über definierte Öffnungen oder Undichtigkeiten aus dem Schrank (2) abgeführt wird.

## Claims

1. Assembly for air conditioning of electronic modular units (4) arranged in an inner area (3) of an equipment and network cabinet, having a closed cooling air circuit and a heat exchanger (5) for dissipating the heat loss produced by the electronic modular units (4),
**characterized in that**
in the vicinity of covering parts (20, 22, 23) of the cabinet (2) openings, interruptions or leaks (7) formed in planned manner are provided and through which external air (6) can be supplied in order to stabilize the atmospheric humidity in the inner area (3) of the cabinet (2).

2. Assembly according to claim 1,
**characterized in that**
the leaks (7) in the cabinet (2) are formed in areas where different pressures prevail inside and outside the cabinet.

3. Assembly according to claim 1 or 2,
**characterized in that**
a leak (7) for external air supply (6) is formed in an underpressure area (8) and a leak (7) for air removal (9) from the cabinet (2) is formed in an overpressure area (10).

4. Assembly according to one of the preceding claims,
**characterized in that**
a leak (7) for external air supply (6) is formed in an area of the suction side of a ventilator (21) for the closed cooling air circuit, e.g. in an area alongside the heat exchanger (5) connected to an exhaust air duct (14).

5. Assembly according to one of the preceding claims,
**characterized in that**
the heat exchanger (5) is an air-water heat exchanger located on the bottom side.

6. Assembly according to one of the claims 3 to 5,
**characterized in that**
the leak (7) for air removal (9) is formed in the area of the air exit side of the ventilator (21), e.g. downstream of the air-liquid heat exchanger (5).

7. Assembly according to one of the preceding claims,
**characterized in that**
the external air supply (6) and air removal (9), as a function of an atmospheric humidity measurement in the cooling air circuit of the cabinet (2), are controllable by the ambient conditions of the cabinet (2) and the target values in the inner area (3) of the cabinet (2).

8. Assembly according to one of the preceding claims,
**characterized in that**
the interruptions (7) for external air supply (6) are formed in the sealing of the cable entry and/or cable exit in the area of a base (18) or in a lower area of the cabinet (2), said area being in each case connected to a first exhaust air duct (14) for a rising exhaust air flow (15).

9. Assembly according to one of the preceding claims,
**characterized in that**
the interruptions (7) for external air supply (6) are formed in a shaft positioned alongside the heat exchanger (5) and connected to the first exhaust air duct (14) for the rising exhaust air flow (15).

10. Assembly according to one of the preceding claims,
**characterized in that**
the seals of the cabinet (2) are formed zonally lower than IP 55 and are water vapour-permeable for external air supply (6).

11. Method for air conditioning of electronic modular units (4) located in an equipment and network cabinet, in which a cooling air flow is circulated in a closed circuit, cold supply air (12) being supplied to the electronic modular units (4) and heated exhaust air (15, 17) is cooled in a heat exchanger (5),
**characterized in that**
the humidity of the air flow is stabilized by a defined supply of external air to prevent a continuous dehumidification of the air circulated in the closed circuit.

12. Method according to claim 11,
**characterized in that**
the absolute humidity of the cooling air flow circulated in the closed circuit is measured and in the case of a deviation from a predeterminable value or range external air (6) is supplied as a function of the ambient conditions of cabinet (2) and the target values within the cabinet (2).

13. Method according to claim 11 or 12,
**characterized in that**
the external air is supplied to the closed cooling air circuit through leaks or interruptions (7) of the cabinet (2) formed in a planned manner.

14. Method according to one of the claims 11 to 13,
**characterized in that**
the external air (6) is supplied via leaks (7) in areas in which prevail differential pressures between the cabinet interior and the environment of the cabinet (2).

15. Method according to one of the claims 11 to 14,
**characterized in that**
the external air (6) is supplied in the area of cable entries and/or exits, e.g. in a base (18).

16. Method according to claim 15,
**characterized in that**
the external air (6) is supplied by means of leaks in the cabinet sealing, particularly in an area alongside the heat exchanger (5), which is an air-liquid heat exchanger and positioned at the bottom below the electronic modular units (4).

17. Method according to one of the claims 11 to 16,
**characterized in that**
the external air is supplied via openings in covering parts (20, 22, 23).

18. Method according to one of the claims 11 to 17,
**characterized in that**
for stabilizing the atmospheric humidity in the cabinet (2) air (9) is removed from said cabinet (2).

19. Method according to claim 18,
**characterized in that**
air (9) is removed from the cabinet (2) by means of clearly defined openings or leaks in overpressure areas (10) of said cabinet (2).

## Revendications

1. Dispositif de climatisation de modules d'unités électroniques (4) installées dans le volume intérieur (3) d'une armoire d'appareillage et de réseau
comprenant un circuit d'air de refroidissement, fermé, et un échangeur de chaleur (5) pour évacuer la chaleur dégagée par les unités de modules électroniques (4),
**caractérisé par**
des orifices, des ouvertures ou des défauts d'étanchéité (7) réalisées de manière précise sont prévus dans la région des pièces d'habillage (20, 22, 23) de l'armoire (2), permettant une alimentation en air extérieur (6) pour stabiliser l'humidité de l'air dans le volume intérieur (3) de l'armoire (2).

2. Dispositif selon la revendication 1,
**caractérisé en ce que**
les défauts d'étanchéité (7) de l'armoire (2) sont prévus dans des zones dans lesquelles règnent des pressions différentes entre l'intérieur de l'armoire et l'extérieur de l'armoire.

3. Dispositif selon l'une quelconque des revendications 1 ou 2,
**caractérisé en ce qu'**
un défaut d'étanchéité (7) est réalisé pour assurer l'alimentation d'air extérieur (6) dans une zone à dépression (8) et un défaut d'étanchéité (7) est prévu pour évacuer l'air (9) de l'armoire (2) dans une zone de haute pression (10).

4. Dispositif selon l'une quelconque des revendications précédentes,
**caractérisé en ce qu'**
un défaut d'étanchéité (7) est réalisé pour assurer l'alimentation en air extérieur (6) dans la région du côté aspiration d'un ventilateur (21) du circuit d'air de refroidissement, fermé, par exemple dans une zone reliée au canal d'évacuation d'air (14), à côté de l'échangeur de chaleur (5).

5. Dispositif selon l'une quelconque des revendications précédentes,
**caractérisé en ce que**
l'échangeur de chaleur (5) est un échangeur air/eau, installé du côté du sol.

6. Dispositif selon l'une quelconque des revendications 3 à 5,
**caractérisé en ce que**
le défaut d'étanchéité (7) pour assurer l'évacuation de l'air (9) est prévu dans la région de la sortie d'air du ventilateur (21), par exemple après l'échangeur de chaleur air/liquide (5).

7. Dispositif selon l'une quelconque des revendications précédentes,
**caractérisé en ce que**
l'alimentation en air extérieur (6) et l'évacuation en air (9) sont commandées en fonction d'une mesure d'humidité de l'air dans le circuit d'air de refroidissement de l'armoire (2), en fonction des conditions d'environnement de l'armoire (2) et en fonction des valeurs cibles dans le volume intérieur (3) de l'armoire (2).

8. Dispositif selon l'une quelconque des revendications précédentes,
**caractérisé en ce que**
des ouvertures (7) pour assurer l'alimentation en air extérieur (6) sont prévues dans les moyens d'étanchéité des entrées de câble et/ou des sorties de câble dans la région du socle (18) ou dans une région inférieure de l'armoire (2), cette région étant respectivement reliée à un premier canal d'air d'évacuation (14) pour un écoulement montant d'air d'évacuation (15).

9. Dispositif selon l'une quelconque des revendications précédentes,
**caractérisé en ce que**
les ouvertures (7) pour l'alimentation en air extérieur (6) sont prévues dans un puits à côté de l'échangeur de chaleur (5) et auquel est relié le premier canal d'air de sortie (14) pour le courant d'air de sortie (15), montant.

10. Dispositif selon l'une quelconque des revendications précédentes,
**caractérisé en ce que**
pour l'alimentation en air extérieur (6), les joints de l'armoire (2) sont réalisés par régions, plus petits que IP 55 et sont perméables à la vapeur d'eau.

11. Procédé de climatisation d'unités de modules électroniques (4) installées dans une armoire d'appareillage et de réseau, selon lequel on fait passer un courant d'air de refroidissement dans un circuit fermé, l'air de refroidissement frais (12) étant fourni aux unités de modules électroniques (4) et l'air de sortie, (15, 17), réchauffé étant refroidi dans un échangeur de chaleur (5),
**caractérisé en ce que**
pour éviter une déshumidification permanente de l'air guidé suivant un circuit fermé, on stabilise l'humidité du courant d'air par une alimentation définie en air extérieur.

12. Procédé selon la revendication 11,
**caractérisé en ce qu'**
on mesure l'humidité absolue du courant d'air de refroidissement conduit dans le circuit fermé et en cas d'écart par rapport à une valeur prédéfinie ou d'une plage prédéfinie, on fournit de l'air extérieur (6) selon les conditions d'environnement de l'armoire (2) et des valeurs cibles dans l'armoire (2).

13. Procédé selon l'une quelconque des revendications 11 ou 12,
**caractérisé en ce que**
l'air extérieur est fourni à travers des défauts d'étanchéité ou des ouvertures (7) de l'armoire (2), réalisées de manière précise pour alimenter le circuit fermé d'air de refroidissement.

14. Procédé selon l'une quelconque des revendications 11 à 13,
**caractérisé en ce que**
l'air extérieur (6) est fourni par des défauts d'étanchéité (7) dans les régions dans lesquelles règnent des différences de pression entre l'intérieur de l'armoire et l'environnement de l'armoire.

15. Procédé selon l'une quelconque des revendications 11 à 14,
**caractérisé en ce qu'**
on fournit l'air extérieur (6) dans la région des entrées de câble et/ou des passages de câble, par exemple dans un socle (18).

16. Procédé selon la revendication 15,
**caractérisé en ce qu'**
on fournit l'air extérieur (6) par des défauts d'étanchéité de l'armoire notamment dans une région à côté de l'échangeur de chaleur (5) qui est un échangeur de chaleur air/liquide et est installé du côté du sol sous les unités de modules électroniques (4).

17. Procédé selon l'une quelconque des revendications 11 à 16,
**caractérisé en ce que**
l'air extérieur est fourni à travers des orifices dans les parties d'habillage (20, 22, 23).

18. Procédé selon l'une quelconque des revendications 11 à 17,
**caractérisé par**
une évacuation d'air (9) hors de l'armoire (2) pour stabiliser l'humidité de l'air dans l'armoire (2).

19. Procédé selon la revendication 18,
**caractérisé en ce que**
l'air (9) des zones à surpression (10) de l'armoire (2) est évacué de cette armoire (2) à travers des orifices définis ou des défauts d'étanchéité.
